Europäisches Patentamt

European Patent Office

Office européen des brevets

(11) Publication number: **0 206 514**
**B1**

## (12) EUROPEAN PATENT SPECIFICATION

(45) Date of publication of patent specification: **10.01.90**

(51) Int. Cl.⁵: **C 30 B 15/12**

(21) Application number: **86303816.2**

(22) Date of filing: **20.05.86**

(54) **Double crucible for single crystal growth.**

(30) Priority: **21.05.85 JP 108788/85**

(43) Date of publication of application:
**30.12.86 Bulletin 86/52**

(45) Publication of the grant of the patent:
**10.01.90 Bulletin 90/02**

(84) Designated Contracting States:
**DE FR GB**

(56) References cited:
**FR-A-2 168 435**
**US-A-2 944 875**
**US-A-3 671 203**

(73) Proprietor: **SUMITOMO ELECTRIC INDUSTRIES LIMITED**
**No. 15, Kitahama 5-chome Higashi-ku**
**Osaka-shi Osaka 541 (JP)**

(72) Inventor: **Nakai, Ryusuke Osaka Works**
**Sumitomo Electric Ind. Ltd. 1-3, Shimaya 1-chome**
**Konohana-ku Osaka (JP)**
Inventor: **Tada, Kohji Osaka Works**
**Sumitomo Electric Ind. Ltd. 1-3, Shimaya 1-chome**
**Konohana-ku Osaka (JP)**

(74) Representative: **Calderbank, Thomas Roger et al**
**MEWBURN ELLIS & CO. 2/3 Cursitor Street**
**London EC4A 1BQ (GB)**

Courier Press, Leamington Spa, England.

**Description**

The present invention relates to a double crucible useful for carrying out crystal growth. More particularly, the present invention pertains to a double crucible used for producing high quality single crystals having a uniform concentration of an impurity doped therein, throughout the whole length of the crystal produced, according to Czochralski method.

In general, single crystals of various kind of semiconductors have been used for realizing different semiconductor elements or devices. Moreover, qualities of semiconductors are significantly influenced by the crystalline structure thereof, that is they may be determined by the crystalline structure. Thus, up to date, there have been proposed different techniques for growing single crystals of semiconductors to obtain an excellent crystal having a more complete structure and a desired composition (for instance, stoichiometric composition). Czochralski method (hereunder, referred to as CZ method, for simplicity), among others, has often been adopted because of the simplicity of procedures for growing crystals.

This CZ method generally comprises melting a starting material for growing single crystal in an inert gas (for instance, Ar) atmosphere of zero to $10^7$ Pa (zero to 100 atms), immersing a seed crystal in molten starting material (melt) around its surface region and then pulling the seed crystal while growing and depositing single crystal around the seed crystal. Thus, the CZ method has widely been utilized conventionally, when single crystals of semiconductors such as silicon (Si), germanium (Ge) or the like, which have a relatively low dissociation pressure at the crystal growth temperature, are produced.

However, in the CZ method, melt of a starting material for single crystal is directly in contact with a crucible containing the same. This, in turn, causes impurity contamination of the resulting single crystal, which is originated from material of the crucible. Thus, it is noted that the material for the crucible should carefully be selected so as not to cause contamination of melt contained therein or it is required to provide with any means for preventing such contamination or for removing impurities from the melt or the growing crystal.

When producing a single crystal of compound semiconductor such as III—V or II—VI compound semiconductors of multi-component, at least one component thereof tends to be decomposed and evaporated at the crystal growth temperature because of their relatively high vapour pressure at the dissociation equilibrium and this, in turn, results in the occurrence of discrepancy in the stoichiometric composition of the crystal produced. In order to overcome such problem, there has been proposed a method for producing single crystals which is referred to liquid encapsulated Czochralski method (LEC method) in which the crystal growth is carried out under the presence of a molten liquid encapsulant such as boron oxide ($B_2O_3$). The molten encapsulant covers the melt surface of the starting material during the crystal growth procedures so as to prevent the high vapour pressure component of the melt from the decomposition and evaporation.

As a recent trend, certain impurities are often added or doped in a single crystal of semiconductor to obtain single crystals of a desired resistivity or to reduce the dislocation density in the resulting single crystals. However, single crystals produced according to CZ method has a distribution of impurity concentration along the crystal growth direction, this is because the impurity concentration in the crucible varies in proportion to the degree of solidification due to the so-called segregation phenomenon and therefore, it is difficult to produce a relatively large single crystal ingot having a uniform distribution of impurity concentration when CZ method is adopted.

Thus, in order to solve such problem of impurity concentration distribution, there have been proposed, different methods such as multiple ingot producing technique, dopant evaporation method, double crucible method (or floating crucible method).

The multiple ingot producing method comprises a plurality of crystal growing steps and is characterized in that each crystal growing step is stopped at an instant when a desired impurity concentration is attained in the growing single crystal and then the growth operation is repeated after making up ingredient and impurity to a crucible and adjusting the impurity concentration in the crucible to a desired level. Thus, the size of the single crystal ingot obtained according to the method is largely restricted and relatively small. In addition, the dopant evaporation method is characterized in that the adjustment of the impurity concentration is performed by adjusting the degree of evaporation of impurity by lowering the inner pressure of a pulling furnace used. However, the dopant evaporation method is effective only if it is applied to a method in which an impurity (or dopant) having a high evaporation velocity is used and thus the use of the method is substantially restricted and is not applied to cases where impurities having a relatively low evaporation velocity are used.

There have been proposed a lot of techniques such as those mentioned above to solve the problems encountered in CZ method due to the segregation phenomenon of the impurity, however, if the multiple ingot producing technique and the dopant evaporation method are employed, they impose further restrictions on CZ method although they can provide single crystals having a relatively uniform distribution of impurity along the whole length of the crystal obtained in a certain specific cases.

On the other hand, double crucible method is an improved CZ or LEC method in which a double crucible consisting of an outer crucible and an inner crucible having a hole communicating the inner space and outer space thereof, at the bottom portion, is used during the single crystal pulling procedures. The inner crucible of the double crucible is suspended in the melt contained in the outer crucible at the vicinity of the single crystal-melt or melt-liquid encapsulant interface due to the balance between gravitational force (or weight of the inner crucible) and buoyancy acting on the inner crucible.

According to the double crucible method, the melt of starting materials in the outer crucible exclusively flows into the inner crucible through the communicating hole formed at the bottom or the lower portion of the side wall in accordance with the degree of solidification or as the grown crystal is pulled up. As a result, the concentration of impurity in the inner crucible is maintained at a desired constant value irrespective of the degree of solidification (or amount of the crystal grown). Moreover, the melt of the starting material may be covered with a liquid encapsulant so that the component of the melt would not escape from the crucible due to dissociation and/or evaporation.

Thus, the distribution of the impurity concentration along the length of the crystal produced may be controlled according to the mechanism discussed above in the double crucible technique. According to this method, there is no restriction such as encountered in the two methods explained above and further single crystals having uniform distribution of impurity may possibly be obtained. In this method, the convection of melt is also restricted in some degree due to the presence of the inner crucible, which is deemed to be preferred to obtain single crystals having a uniform quality.

However, in the double crucible method, the inner crucible simply floats in the vicinity of the melt-liquid encapsulant interface and therefore, the inner crucible is rather unstable and strongly influenced by any external forces such as mechanical vibrations, which cause the fluctuation of the single crystal- melt interface, the destruction of the thermal stability of the interface (uniform temperature distribution around the interface) and the modulation of the melt convection. Such phenomenon causes, in turn, the formation of polycrystals. In addition, the vibration (or upward and downward movement) of the inner crucible entrains the movement of the inner crucible such as vibration, thereby the melt flows in or out the inner crucible through a communicating hole thereof depending on the behavior of the inner crucible. This makes it impossible to maintain a constant concentration of melt, more precisely a uniform impurity concentration, in the inner crucible.

As seen from the above description, there have conventionally been proposed various kinds of methods for growing single crystals of semiconductors and they have widely been employed. However, since quality of semiconductor devices is substantially influenced by the crystalline structure, in particular, the uniformity of the composition (inclusive of dopant distribution) of the crystalline material and its completeness. These methods should further be improved so as to obtain single crystals of semiconductor having an excellent quality and to provide semiconductor devices having an improved reliability. Thus, the method for growing single crystals of compound semiconductors has stepwise been improved from CZ method to LEC method and further to the double crucible method. In particular, the double crucible method is effective to obtain a single crystal having a uniform impurity distribution compared with the multiple ingot producing technique and the dopant evaporation method and it has widely been utilized in this field. However, as already mentioned before, the double crucible method also has different disadvantages to be overcome, due to the inherent reason concerning the double crucible structure, since the inner crucible is in the floating state during the crystal growth operations. It is quite significant to eliminate the above mentioned difficulties encountered in practicing the double crucible method, thereby providing a method for growing high quality single crystals of uniform dopant or impurity distribution throughout the whole length thereof and, in turn, improving qualities of the semiconductor devices formed using such single crystal and assuring their high reliability.

Thus, a principal object of the present invention resides in improving the double crucible method among others, which may possibly permit the production of single crystals of quite uniform impurity distribution;

The purpose of the invention, more particularly, resides in improving double crucible itself, in particular, the construction of inner crucible used therein, which is inherently unstable against the action of external forces and stabilizing the double crucible.

Another purpose of this invention is to provide a method for producing single crystals in a pull furnace in which the double crucible improved according to the present invention is utilized.

A further object of the present invention is to provide single crystals having an excellent quality such as highly uniform dopant distribution utilizing the improved double crucible.

The above mentioned and other purposes of the present invention can be accomplished by providing a method for growing single crystals according to the double crucible method using an apparatus comprising an inner crucible (30, 40) and an outer crucible (3) said inner crucible (30, 40) having at least one communicating hole (34) at the lower portion thereof, characterized in that the area $S_1$ of the cross section of the inner crucible wall at the melt of starting material-single crystal interface is enlarged and determined so that the following requirement is satisfied:

$$S_1(\rho_M - \rho_B) > 100 \text{ g/cm} \tag{a}$$

wherein $\rho_M$ is the density of the melt of the starting material and $\rho_B$ is the density of a liquid encapsulant eventually used, and that the cross sectional area $S_2$ of the internal space of the outer crucible (3) at the melt-single crystal interface is determined so as to fulfil the following requirement:

3

$$S_1/S_2 > 1/100 \qquad\qquad (b)$$

The double crucible employed in the method of the present invention will now be described in more detail with reference to the following attached drawings: wherein

Fig. 1 shows the dopant concentration variation plotted against the length of the crystal along its growth direction, in which the result obtained according to CZ method (A) is compared with that of the double crucible method (B);

Fig. 2 is an illustrative vertical sectional view of a conventional double crucible;

Figs. 3a and 3b and Figs. 4a to 4d show two different preferred embodiments of the double crucible according to the present invention, as illustrative vertical sectional views respectively;

Fig. 4e shows a vertical sectional view of an embodiment of communicating hole of the inner crucible of the present invention; and

Fig. 5 shows an example of a pull furnace according to LEC method to which the double crucible according to the present invention is applied, as an illustrative vertical sectional view.

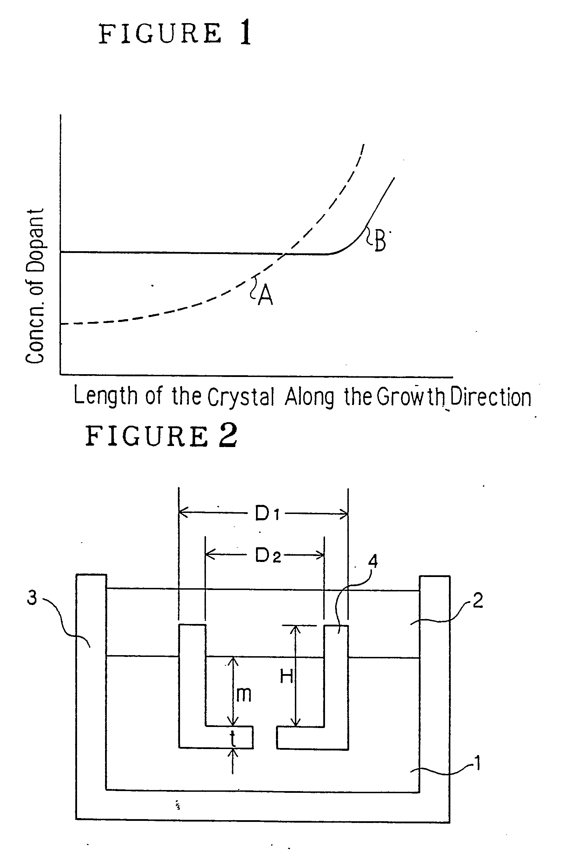

As already mentioned, among the crystal growth techniques conventionally proposed and employed in the art, the double crucible method is considered to be one of the most preferred methods for growing crystals and according to this method, the formation of single crystals having a uniform dopant distribution may be expected. As seen from the results shown in Fig. 1, the dopant concentration in the inner crucible or the dopant distribution in crystals obtained according to CZ method substantially varies along the crystal length due to the segregation phenomenon (Curve A), while it is found that the dopant distribution in crystals obtained according to the double crucible method is almost uniform throughout the whole length of the crystal grown except for the extremity produced at the end of the growth operation (see Curve B of Fig. 1).

Fig. 2 shows an example of a conventional double crucible applied to LEC method. The double crucible is, in this example, composed of an outer crucible 3 containing melt 1 of starting material for crystal growth and a liquid encapsulant 2 therein and an inner crucible 4 disposed in the outer crucible 3. The inner crucible 4 floats around the interface between the liquid encapsulant 2 and the melt 1 of starting material due to the balance between the weight of the inner crucible (or gravitational force) and the buoyancy originated in the liquid encapsulant 2 and the melt 1 and thus the internal volume of the inner crucible is surely maintained at a constant value. However, the conventional double crucible as shown in Fig. 2 has many problems to be solved, in particular, those resulting from the fact that the inner crucible is in the float state and unstable. This causes various kinds of disadvantages such as those already mentioned above.

Under such circumstances, the inventors have deeply required into and studied on the construction of the conventionally double crucible and found that the disadvantages encountered in the conventional double crucible are mainly caused due to the small sectional area of the inner crucible at the interface of the melt. As a result, the crucible is greatly affected by the action of an external force such as mechanical vibration and thereby disadvantages such as turbulence of the melt surface, distribution of dopant concentration in single crystals produced and the formation of polycrystals. The inventors have, thus, found that these problems can surely be overcome by careful selection of materials for the crucible and by increasing the cross sectional area at the melt-liquid encapsulant or melt-growing crystal interface.

Now, referring to the attached Fig. 2, the motion of the inner crucible when an external force is accidentally applied thereto and the conditions required to restrict the motion thereof are, hereunder, considered and discussed in more detail.

Under the condition shown in Fig. 2, the buoyancy (Fv) acting on the inner crucible 4 is represented by the following equation:

$$Fv=\left\{\frac{\pi D_1^2 t}{4}+\frac{\pi(D_1^2-D_2^2)m}{4}\right\}\rho_M+\frac{\pi(D_1^2-D_2^2)(H-m)}{4}\rho_B \qquad (1)$$

wherein

$\rho_M$: density of the melt of the starting material;
$\rho_B$: density of the liquid encapsulant;
$D_1$: outer diameter of the inner crucible;
$D_2$: inner diameter of the inner crucible;
t: thickness of the bottom portion of the inner crucible;
m: depth of the melt in the inner crucible (the melt depth);
H: net depth of the inner crucible.

On the other hand, the weight (W) of the inner crucible 4 is represented by the following equation:

$$W=\frac{\pi}{4}\{D_1^2 t+(D_1^2-D_2^2)H\}\rho_c \qquad (2)$$

wherein $\rho_c$ means the density of the material for the crucible.

4

Thus, it is needed to satisfy the following relationship in order to hold the inner crucible in the floating state and to keep the stationary and equilibrium state, shown in Fig. 2 due to the balance between the weight of the crucible and the buoyancy acting thereon:

$$Fv - W = 0 \tag{3}$$

While, the stability of the inner crucible may generally be estimated based on the strength of restoring force acting on the inner crucible just when the melt depth m in the inner crucible is intentionally changed by a constant value from its equilibrium depth. That is, the strength of the restoring force (the magnitude of the buoyancy) serving to recover the equilibrium state defined by the above relation (3), when the melt depth is changed by dm from the equilibrium state, is expressed by the following equation:

$$\frac{d(Fv - W)}{dm} = \frac{dFv}{dm} = \frac{\pi}{4}(D_1^2 - D_2^2)(\rho_M - \rho_B) \tag{4}$$

Moreover, the equation (4) can further be simplified as follows:

$$\frac{dFv}{dm} = S_1(\rho_M - \rho_B) \tag{5}$$

since the sectional area of the wall of the inner crucible at the melt-liquid encapsulant interface ($S_1$) is equal to $\pi(D_1^2 - D_2^2)/4$.

In the equation (5), the term $(\rho_M - \rho_B)$ is constant, if once the starting material and the kind of the liquid encapsulant are specified. Therefore, the equation (5) teaches the fact that the more the sectional area $S_1$ is large, the more the strength of the term dFv/dm becomes high as well as the more the stability of the inner crucible becomes high. Thus, the occurrence of vibrations due to, for example, the action of an accidental external force can effectively be prevented or even if the vibration is caused, the amplitude of the vibration caused by the action of such external force can easily be restricted to a minimum value and furthermore, the relaxation time of the vibration can remarkably be reduced by increasing the cross sectional area of the inner crucible according to the present invention.

Practically, it is found that if the following two conditions (a) and (b) are satisfied simultaneously, the production of an excellent single crystal may surely be expected according to our experimental results:

$$S_1(\rho_M - \rho_B) > 100 \text{ g/cm} \tag{a}$$

$$S_1/S_2 > 1/100 \tag{b}$$

wherein the symbols have the same meanings as those defined above.

By way of a concrete example, when single crystal of GaAs is produced utilizing boron oxide ($B_2O_3$) as the liquid encapsulant, the area $S_1$ of the cross section of the inner crucible wall must be more than 24.33 $cm^2$, since the densities of GaAs and $B_2O_3$ are 5.71 $g/cm^3$ and 1.60 $g/cm^3$ respectively, according to the condition (a). While, the cross sectional area $S_2$ of the outer crucible should be selected so that the condition (b): $S_1/S_2 > 1/100$ would always be satisfied. This is true for any other combinations of starting materials for crystal growth and liquid encapsulant and therefore, in any cases, the sectional areas $S_1$ and $S_2$ may easily be calculated on the basis of the physical properties of the starting materials and liquid encapsulant interested or selected and thus a desired double crucible can easily be designed.

Thus, according to the present invention, it becomes possible to overcome the encountered disadvantages by increasing the area of the cross section of the inner crucible wall.

This is not practicable for conventional double crucibles, made from a single material such as pyrolytic boron nitride (PBN) or quartz. A conventional form of inner crucible produced of such a single material cannot have an enlarged area of the cross-section of the inner crucible wall; it would, for example, be too heavy. Furthermore, even if a crucible having a wall of large cross sectional area were formed using a single material (but conventional design), the weight W and the melt depth m thereof could not be independently selected. This makes it impossible to attain an optimized stable state of the inner crucible, for instance, the optimum melt depth m and a sufficient area of the cross section of the inner crucible wall at the interface between the melt and the growing crystal (or liquid encapsulant). While, according to the double crucible of the present invention, all the difficulties encountered in the conventional double crucible method can certainly be eliminated. In other words, the double crucible according to the present invention permits the reduction of deviation from the equilibrium state even if the inner crucible is affected by an external force and causes, for instance, vibration and the reduction of the relaxation time of the vibration (or time needed for restoring the equilibrium state). The double crucible of the present invention further makes it possible to solve the problems such as the formation of polycrystals due to the vibration of fluctuation or the interface and the variation of the dopant concentration in the inner crucible and thus

5

uniform and high quality single crystals of semiconductors can be provided according to a single crystal manufacturing process utilizing the double crucible of the present invention.

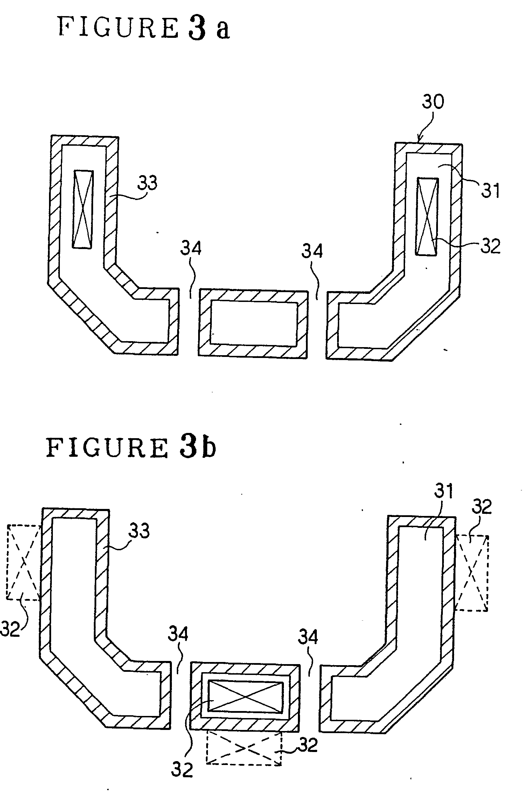

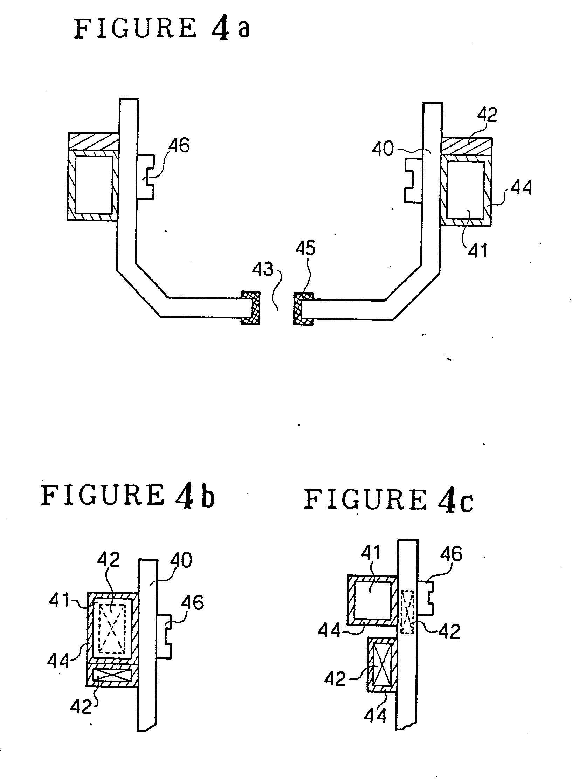

Two different and preferred examples of the double crucibles according to the present invention are illustratively shown in Figs. 3a, 3b and 4a to 4d in which, for simplicity of the explanation, only the inner crucible or a part thereof is shown.

First of all, in the first example of the double inner crucible according to the present invention, shown in Fig. 3a, the inner crucible 30 is comprised of a body 31 of crucible having thick wall, sinkers 32 embedded within the body 31 and a coating film 33 which covers the whole surface of the body 31. The inner crucible 30 has at least one communicating hole 34 at the bottom portion of the body 31 (in this embodiment, there are two such holes), which permits the passage of the melt of starting material and dopants (impurities) contained in the outer crucible (not shown), these being preferentially flowing into the inner crucible corresponding to the degree of consumption of them contained therein. The inner surface of the communicating hole 34 is also covered with the coating film 33. The sinker 32 may also be disposed on the side wall of the body 31 or at the bottom thereof (see the dotted line in Fig. 3b). In such cases, the sinkers 32 should symmetrically be arranged in line with the central axis so that the center of gravity of the body of crucible and that of the sinkers may coincide with each other. The number of sinkers used is not limited to a certain number and the sinkers of any shape may also be used in the present invention. While, if the sinker is disposed on the side wall of the body, it is preferred to use at least 2 sinkers to maintain the inner crucible in the horizontal state and its length along the horizontal direction may preferably be long enough to assure the horizontal position of the crucible. When the sinker is disposed on the bottom of the body, only a single sinker may, however, be used. Moreover, the sinkers 32 may be placed on not only the side wall but the bottom of the body 31 as shown in Fig. 3b by dotted line.

Examples of the preferred material for producing the double crucible according to the present invention, include materials which may be processed without any difficulty and have a low density as well as which are stable around the temperature of the melt of the starting material. There may be mentioned such a material for double crucible as carbon, aluminium nitride (AlN), boron nitride (BN), silicon nitride (SiN) as the typical examples therefor. On the other hand, there may be mentioned such as molybdenum (Mo), which is stable at the temperature of the melt and has a high density, as the preferred example of the material for the sinker used herein. In addition, tungsten (W), tantalum (Ta), lead (Pb) gallium (Ga), indium (In) may also be utilized as the material for the sinker. As typical examples of the coating film material, there may be mentioned such as known materials for conventional crucible, for instance, PBN, AlN, BN, quartz, which does not have a tendency to contaminate the melt of the starting material. These coating films may be deposited on the surface of the body and the inner surface of the communicating hole, by a conventional technique for forming thin films such as chemical vapour deposition method (CVD method). The thickness thereof is not critical and generally in the order of approximately 100 μm which is sufficient to achieve a desired effect.

Another preferred embodiment of the double crucible according to the present invention is illustrated in Fig. 4a. This embodiment is composed of, as in the case shown in Figs. 3a and 3b, a body of the inner crucible 40, floaters 41 disposed on the side wall of the body at the interface of the melt of the starting material for growing single crystal, sinkers 42 placed on the floaters 41, coating films 44 and 45 which cover the surface of the floater 41 (eventually the surface of the sinker 42) and the inner surface of the communicating hole 45 formed at the bottom of the body 40. The assembly of the floater 41 and the body 40 of the inner crucible may be performed, for example, by utilizing a screw bolt 46 (made from, for instance, PBN or BN) which has no tendency to contaminate the melt and is stable at the temperature of the melt. In this embodiment, the sinker 42 does not, in general, contact with the melt of the starting material and therefore, there is no problem of the contamination of the melt due to the sinker and therefore, the sinker must not always be covered with coating film 44.

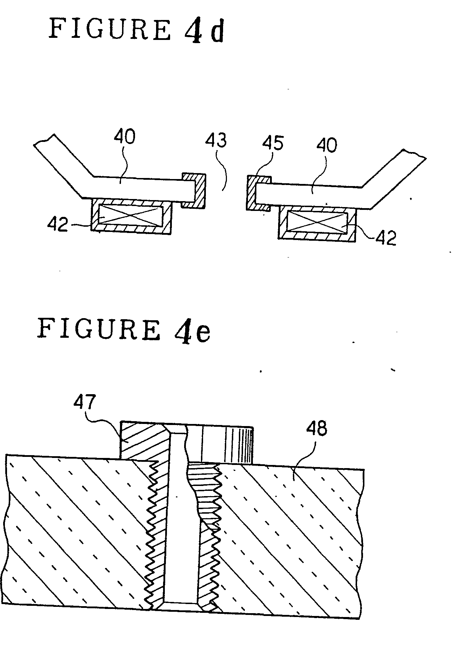

As the material for each element of the double crucible, there may be mentioned such as conventional materials used for manufacturing crucible (this is because, in this embodiment, the side wall must not be thick) as the material for the body 40 and the preferred material for coating film 44 is PBN which does not cause contamination of the melt; the preferred material for floater 41 is BN, carbon, SiN, AlN having a low density so as to increase the cross sectional area thereof. On the other hand, the communicating hole 43 may be covered with a film 45 of quartz, PBN, BN causing only a small frictional force against the melt of the starting material or it may also be formed by the combination of a bolt 47 and a nut 48 of BN, PBN as shown in Fig. 4e.

In the embodiment shown in Fig. 4, it should be understood that the sinker 42 may also be disposed at the lower part of the floater 41 (see Fig. 4b), at the bottom of the body 40 (see Fig. 4d), or on the side wall of the body 40 (see Fig. 4c) and these embodiments also falls within this invention. In addition, as shown by the dotted line (Figs. 4b and 4c), it may also be possible to embed the sinker 42 within the floater 41 or within the body 40 of the inner crucible. In these cases, the sinker must be covered with, for instance, PBN or the like if the sinker directly contacts with the melt and causes contamination thereof. Desired number of the sinkers should be arranged symmetrically along the central axis of the crucible so that the center of gravity of the body or the whole body inclusive of floaters coincides with that of the sinkers 42. The identical attention must be paid in arranging the floaters 41 around the side wall of the inner crucible.

Thus, the double crucible according to the present invention has an extremely high stability because of

6

its large cross sectional area which permits the reduction of the magnitude of the motion such as the vibration caused by external forces. Therefore, a lot of disadvantages encountered in the conventional double crucible method, which, in particular, permits the production of single crystals having a uniform impurity distribution, can almost be eliminated without any difficulties and the use of such double crucible enables the double crucible method to exhibit its inherent characteristics mentioned above. That is to say, the double crucible of the present invention makes it possible to produce high quality single crystals of semiconductors having a uniform impurity concentration throughout the whole length of the crystals grown, in an improved high yield. This, in turn, makes it possible to remarkably improve the yield of wafers per ingot obtained in the above method employing the new double crucible and significantly reduce the cost for manufacturing single crystals.

The double crucible according to the present invention may be used in different kinds of pulling furnace and applied effectively to CZ method, LEC method depending on the nature and the kind of starting materials and/or single crystals to be grown. Thus, the double crucible according to the present invention permits the growth of single crystals such as Si, Ge which may optionally be doped with a various kinds of dopant (or impurity) as well as the single crystals of III—V or II—VI compound semiconductors optionally doped with impurity and surely provides single crystal products having an excellent quality, in an improved high yield or productivity.

Application of the double crucible in LEC method

The application of the double crucible according to the present invention will now be explained hereunder and a single crystal of a compound semiconductor is produced according to LEC method in which the double crucible is used.

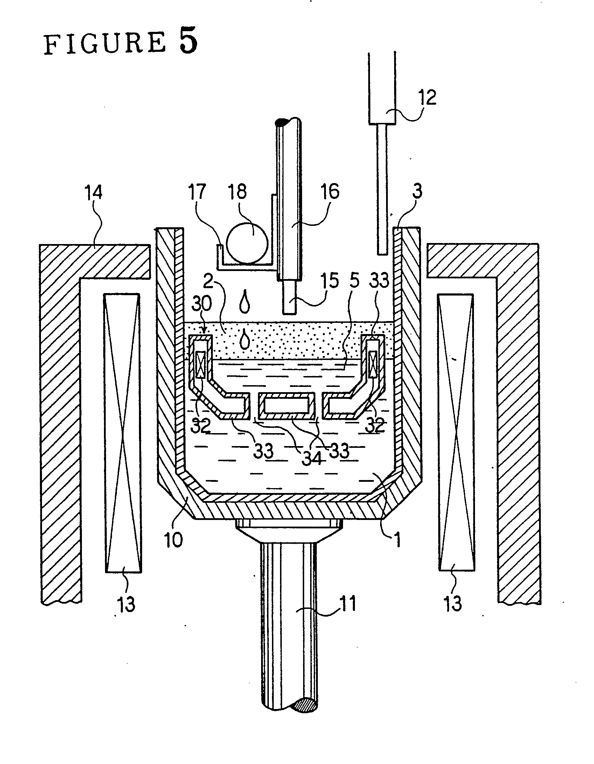

Fig. 5 shows an apparatus for growing single crystal according to LEC method, in which the double crucible of the present invention is incorporated therein. In this example, GaAs single crystal containing In as impurity was produced. In Fig. 5, the double crucible used herein is provided with an inner crucible 30 as shown in Fig. 3a, which is constituted by a carbon body 31, sinkers 32 of Mo embedded in the body 31 and film 33 covering the surface of the body and the inner surface of the communicating hole 34, the film being composed of PBN deposited according to CVD technique. The size of the inner crucible is equal to 148 mm (outer diameter: $D_1$)×110 mm (inner diameter: $D_2$), with the net depth H of 40 mm.

As the outer crucible 3, a crucible of PBN having the inner diameter of 150 mm is used, which is supported by a lower shaft 11 through a susceptor 10. To the outer crucible 3, about 4 Kg of GaAs starting material and 12 g of In were charged and then the inner crucible 30 was disposed on the charged materials while supporting the crucible with a movable tool 12 and further 800 g of liquid encapsulant 2 ($B_2O_3$) was charged thereon. Then, $15×10^5$ Pa (15 atms) of pressure was established in the growing chamber by introducing $N_2$ gas, heater 13 was started to melt the GaAs, In and $B_2O_3$ and then the inner crucible 30 was released after sinking it to a sufficient depth (about 10 mm deeper than the depth of the equilibrium position) by handling the movable tool 12. The desired temperature of these crucibles 3 and 30 can be assured by the power control of heaters and the presence of heat insulators 14. The inner crucible 30 rise up to a position situated at 20 mm higher than the bottom of the outer crucible 3 and the crucible 30 was equilibrated at that position (stationary position or equilibrium position). The upper shaft 16, to the bottom of which a seed crystal 15 was attached, was gradually lowered. The upper shaft 16 is provided with a tool 17 on which about 48 g InAs 18 is disposed. First of all, the melt of InAs 18 was dropped in the inner crucible 30 and thus In was introduced therein. As a result, the In concentration of the melt in the outer crucible 3 was set at 0.3%, while that of the melt in the inner crucible 30 was set at 3.0%. The segregation coefficient of In with respect to GaAs is equal to 0.1, while the In concentration in the inner melt 5 contained in the crucible 30 is maintained at a desired constant value because the melt in the outer crucible 3 preferentially flows into the inner crucible 30 through the communicating hole 34 is proportional to the degree of crystal growth (or degree of solidification).

3 Kg of GaAs single crystal was thus produced and the In concentration falls within 0.30 (±0.01)% from its front part to its back part. In this example, In was introduced to reduce the dislocation density. It was found that dislocation density of the resulting single crystal is 0 to 1,000/cm$^2$ throughout the whole length of the GaAs single crystal obtained.

By way of comparison, GaAs single crystal was also produced according to the conventional LEC method under the same conditions as mentioned before, except that a conventional double crucible was used. In the resulting single crystal ingot, only 1 Kg thereof at the front part had the dislocation density of the order of 0 to 1,000/cm$^2$.

The single crystal obtained according to the double crucible of this invention is highly pure and a semi-insulating crystal having the electric resistivity of at least $10^7$ Ω·cm.

Although, the double crucible according to the present invention has been explained in detail, in connection with the preferred and non-limitative embodiments, it is not intended to restrict the scope of the invention to the particular form as set forth above, on the contrary, it is intended to cover various kinds of alternatives, modifications and equivalents as may be included within the invention as defined by the appended claims. As such modification, there may be mentioned such as the double crucible in which the side wall of the inner crucible is thick and floaters are also disposed, realized by combining the embodiments shown in Figs. 3 and 4 as well as a double crucible which may float around the melt-liquid encapsulant interface, while eliminating the use of the sinkers by careful selection of the material for producing floaters.

## Claims

1. A method for growing single crystals according to the double crucible method using an apparatus comprising an inner crucible (30, 40) and an outer crucible (3) said inner crucible (30, 40) having at least one communicating hole (34) at the lower portion thereof, characterized in that the area $S_1$ of the cross section of the inner crucible wall at the melt of starting material-single crystal interface is enlarged and determined so that the following requirement is satisfied:

$$S_1(\rho_M - \rho_B) > 100 \text{ g/cm} \qquad (a)$$

wherein $\rho_M$ is the density of the melt of the starting material and $\rho_B$ is the density of a liquid encapsulant eventually used,
and that the cross sectional area $S_2$ of the internal space of the outer crucible (3) at the melt-single crystal interface is determined so as to fulfil the following requirement:

$$S_1/S_2 > 1/100. \qquad (b)$$

2. A method according to claim 1 wherein the increase in the area $S_1$ of the cross section of the inner crucible wall is effected by increasing the thickness of the side wall of the inner crucible (30).

3. A method according to claim 2 wherein material for the body (31) of the inner crucible (30) is selected from carbon, boron nitride, silicon nitride and aluminium nitride.

4. A method according to claim 3 wherein the inner crucible (30) has a coating film (33) covering the body (31) thereof and material for the film (33) is selected from pyrolytic boron nitride and aluminium nitride.

5. A method according to any one of claims 2 to 4 wherein the inner crucible (30) has sinkers (32) disposed on or embedded in at least one of the side wall and the bottom of the inner crucible body (31) so that the sinkers (32) are symmetrically arranged around the central axis of the body (31) and the centers of gravity of the sinkers (32) and the body (31) coincide with each other.

6. A method according to claim 1 wherein the increase in the area of the cross section of the inner crucible wall is accomplished by disposing floaters (41) on the side wall of the body of the inner crucible (40) so that they are symmetrically arranged around the central axis of the body and the centers of gravity of the body and the floaters (41) coincide with each other.

7. A method according to claim 6 wherein the body of the inner crucible (40) is made from a material selected from pyrolytic boron nitride, carbon, boron nitride, silicon nitride and aluminium nitride and the floaters (41) are made from a material selected from carbon, boron nitride, silicon nitride and aluminium nitride.

8. A method according to claim 7 wherein the body of the inner crucible (40) and the floaters (41) are made from a material selected from carbon, boron nitride and silicon nitride.

9. A method according to claim 7 or claim 8 wherein the inner crucible (40) has a coating film covering the surface of the body and the floaters and the film is made from pyrolytic boron nitride or aluminium nitride.

10. A method according to any one of claims 6—9 wherein the inner crucible (40) has sinkers (42) disposed on or embedded in at least one of the side wall and the bottom of the body so that they are symmetrically arranged around the central axis of the body and the centers of gravity of the body inclusive of the floaters (41) and of the sinkers (42) coincide with each other.

11. A method according to claim 5 or claim 10 wherein the sinkers (32, 42) are made of a material selected from Mo, W, Ta, Pb, Ga and In.

12. A method according to any one of the preceding claims wherein the inner crucible (30, 40) has a coating film (33) which covers the inner surface of the communicating hole (34) and the material therefor is selected from quartz, pyrolytic boron nitride and boron nitride.

13. A method according to any one of the preceding claims wherein the communicating hole (34) is composed of a bolt (47) and a nut (48) made from boron nitride or pyrolytic boron nitride.

## Patentansprüche

1. Verfahren zum Ziehen von Einkristallen gemäß dem Doppeltiegel-Verfahren unter Verwendung einer Vorrichtung mit einem inneren Tiegel (30, 40) und einem äußeren Tiegel (3), wobei der innere Tiegel (30, 40) wenigstens eine Verbindungsöffnung (34) an seinem unteren Abschnitt aufweist, dadurch gekennzeichnet, daß der Bereich ($S_1$) des Querschnitts der inneren Tiegelwand auf Höhe der Grenzfläche der Schmelze aus Ausgangsmaterial und Einkristall vergrößert ist und so festgelegt ist, daß die folgende Beziehung erfüllt ist:

$$S_1(\rho_M - \rho_B) > 100 \text{ g/cm} \qquad (a)$$

wobei $\rho_M$ die Dichte der Schmelze des Ausgangsmaterials ist und $\rho_B$ die Dichte eines gegebenenfalls verwendeten flüssigen Abdeckmaterials ist,

und daß der Querschnittsbereich $S_2$ des Innenraums des äußeren Tiegels (3) an der Grenzschicht zwischen Schmelze und Einkristall so festgelegt ist, daß die folgende Beziehung erfüllt ist:

$$S_1/S_2 > 1/100. \qquad (b)$$

2. Verfahren nach Anspruch 1, bei dem die Zunahme des Bereichs ($S_1$) des Querschnitts der inneren Tiegelwand durchgeführt wird durch Erhöhung der Dicke der Seitenwand des inneren Tiegels (30).

3. Verfahren nach Anspruch 2, bei dem das Material für das Gehäuse (31) des inneren Tiegels (30) ausgewählt wird aus Kohlenstoff, Bornitrid, Siliziumnitrid und Aluminiumnitrid.

4. Verfahren nach Anspruch 3, bei dem der innere Tiegel (30) eine Deckschicht (33) aufweist, die sein Gehäuse (31) bedeckt und daß das Material für die Schicht (33) ausgewählt wird aus pyrolytischem Bornitrid und Aluminiumnitrid.

5. Verfahren nach einem der Ansprüche 2 bis 4, bei dem der innere Tiegel (30) mit Absenkgewichten (32) versehen ist, die an wenigstens einer der Seitenwände und dem Boden des inneren Tiegelgehäuses (31) angeordnet oder eingebettet sind, derart, daß die Absenkgewichte (32) symmetrisch um die zentrale Achse des Gehäuses (31) verteilt sind, so daß die Schwerpunkte der Absenkgewichte (32) und des Gehäuses (31) zusammenfallen.

6. Verfahren nach Anspruch 1, bei dem die Zunahme des Bereichs des Querschnitts der inneren Tiegelwand erzielt wird durch die Anordnung von Schwimmern (41) an der Seitenwand des Gehäuses des inneren Tiegels (40), derart, daß sie symmetrisch um die zentrale Achse des Gehäuses angeordnet sind und die Schwerpunkte des Gehäuses und der Schwimmer (41) zusammenfallen.

7. Verfahren nach Anspruch 6, bei dem das Gehäuse des inneren Tiegels (40) aus einem Material besteht, das ausgewählt wird aus pyrolytischem Bornitrid, Kohlenstoff, Bornitrid, Siliziumnitrid und Aluminiumnitrid und daß die Schwimmer (41) aus einem Material bestehen, das ausgewählt wird aus Kohlenstoff, Bornitrid, Siliziumnitrid und Aluminiumnitrid.

8. Verfahren nach Anspruch 7, bei dem das Gehäuse des inneren Tiegels (40) und die Schwimmer (41) aus einem Material bestehen, das ausgewählt wird aus Kohlenstoff, Bornitrid und Siliziumnitrid.

9. Verfahren nach Anspruch 7 oder 8, bei dem der innere Tiegel (40) eine Deckschicht aufweist, die die Oberfläche des Gehäuses und der Schwimmer bedeckt und daß die Schicht aus pyrolytischem Bornitrid oder Aluminiumnitrid besteht.

10. Verfahren nach einem der Ansprüche 6 bis 9, bei dem der innere Tiegel (40) mit Absenkgewichten (42) versehen ist, die an wenigstens einer der Seitenwände und dem Boden des Gehäuses angeordnet oder eingebettet sind und zwar symmetrisch zur zentralen Achse des Gehäuses, so daß die Schwerpunkte des Gehäuses einschließlich der Schwimmer (41) mit denjenigen der Absenkgewichte (42) zusammenfallen.

11. Verfahren nach Anspruch 5 oder 10, bei dem die Absenkgewichte (32, 42) aus einem Material bestehen, das aus Mo, W, Ta, Pb, Ga und In ausgewählt ist.

12. Verfahren nach einem der vorhergehenden Ansprüche, bei dem der innere Tiegel (30, 40) eine Deckschicht (33) aufweist, welche die Innenfläche der Verbindungsöffnung (34) bedeckt und daß das Material dafür ausgewählt wird aus Quarz, pyrolytischem Bornitrid und Bornitrid.

13. Verfahren nach einem der vorhergehenden Ansprüche, bei dem die Verbindungsöffnung (34) aus einem Bolzen (47) und einer Mutter (48) besteht, die aus Bornitrid oder pyrolytischem Bornitrid gefertigt wurden.

**Revendications**

1. Un procédé pour faire croître des monocristaux en creuset double en utilisant un appareil comprenant un creuset interne (30, 40) et un creuset externe (3), ledit creuset interne (30, 40) présentant au moins un trou de communication (34) à sa partie inférieure, caractérisé en ce que la surface $S_1$ de la section transversale de la paroi du creuset interne à l'interface matériau de départ-monocristal est agrandie et déterminée de façon à satisfaire la condition suivante:

$$S_1(\rho_M - \rho_B) > 100 \text{ g/m} \qquad (a)$$

dans laquelle $\rho_M$ est la densité du matériau de départ en fusion et $\rho_B$ est la densité d'un encapsulant de liquide utilisé éventuellement,

et en ce que la surface $S_2$ de la section transversale de l'espace interne du creuset externe (3) à l'interface produit en fusion-monocristal est déterminée de façon à remplir la condition suivante:

$$S_1/S_2 > 1/100 \qquad (b)$$

2. Un procédé selon la revendication 1, dans lequel l'accroissement de la surface $S_1$ de la section

**EP 0 206 514 B1**

transversale de la paroi de creuset interne est effectué en augmentant l'épaisseur de la paroi latérale du creuset interne (30).

3. Un procédé selon la revendication 2, selon lequel le matériau pour le corps (31) du creuset interne (30) est soit en carbone, soit en nitrure de bore, soit en nitrure de silicone soit en nitrure d'aluminium.

4. Un procédé selon la revendication 3, selon lequel le creuset interne (30) présente un film de revêtement (33) recouvrant le corps (31) de celui-ci, le matériau du film étant soit en nitrure de bore pyrolytique soit en nitrure d'aluminium.

5. Un procédé selon l'une quelconque des revendications 2 à 4, selon lequel le creuset interne (30) présente des platines (32) disposées sur la paroi latérale et sur le fond du corps (31) du creuset interne ou au moins sur l'un des deux ou encastrées au moins dans l'un des deux de façon à ce que les platines (32) soient disposées symétriquement autour de l'axe central du corps (31) et de façon à ce que les centres de gravité des platines (32) et du corps (31) coïncident entre eux.

6. Un procédé selon la revendication 1, selon lequel l'accroissement de la surface de la section transversale de la paroi du creuset interne soit obtenu en disposant des flotteurs (41) sur la paroi latérale du corps du creuset interne (40) de façon à ce qu'ils soient disposés symétriquement autour de l'axe central du corps et que les centres de gravité du corps et des flotteurs coïncident entre eux.

7. Un procédé selon la revendication 6, selon lequel le corps du creuset interne (40) est réalisé soit en nitrure de bore pyrolytique, soit en carbone, soit en nitrure de bore, soit en nitrure de silicone soit en nitrure d'aluminium et les flotteurs (41) sont réalisés soit en carbone, soit en nitrure de bore, soit en nitrure de silicone, soit en nitrure d'aluminium.

8. Un procédé selon la revendication 7, selon lequel le corps du creuset interne (40) et les flotteurs (41) sont réalisés soit en carbone, soit en nitrure de bore soit en nitrure de silicone.

9. Un procédé selon la revendication 7 ou la revendication 8, selon lequel le creuset interne (40) présente un film de revêtement recouvrant la surface du corps et les flotteurs et selon lequel le film est réalisé en nitrure de bore pyrolytique ou en nitrure d'aluminium.

10. Un procédé selon l'une quelconque des revendications 6 à 9, selon lequel le creuset interne (40) présente des platines (42) disposées sur la paroi latérale ou le fond du corps ou au moins sur l'un des deux, ou encastrées dans au moins l'un des deux, de sorte qu'elles soient disposées symétriquement autour de l'axe central du corps et que les centres de gravité du corps, y compris les flotteurs (41) et les platines (42) coïncident entre eux.

11. Un procédé selon la revendication 5 ou 10, selon lequel les platines (35, 42) sont fabriquées en une matière choisie parmi Mo, W, Ta, Pb, Ga et In.

12. Un procédé selon l'une quelconque des revendications précédentes selon lequel le creuset interne (30, 40) présente un film de revêtement (33) qui recouvre la surface interne du trou de communication (34) et qui est réalisé soit en quartz, soit en nitrure de bore pyrolytique soit en nitrure de bore.

13. Un procédé selon l'une quelconque des revendications précédentes selon lequel le trou de communication (34) est constitué d'un boulon (47) et d'un écrou (48) réalisés en nitrure de bore ou en nitrure de bore pyrolytique.

# FIGURE 1

Concn. of Dopant

Length of the Crystal Along the Growth Direction

# FIGURE 2

# FIGURE 3 a

# FIGURE 3 b

# FIGURE 4 a

# FIGURE 4 b

# FIGURE 4 c

# FIGURE 4 d

# FIGURE 4e

FIGURE 5